# EUROPÄISCHE PATENTANMELDUNG

(11) **EP 3 151 641 A1**
(43) Veröffentlichungstag der Anmeldung: **05.04.2017**
(21) Anmeldenummer: 15187516.8
(22) Anmeldetag: 30.09.2015
(51) Int. Cl.: H05K 3/12, B29C 67/00, H05K 3/34

(54) **VERFAHREN UND VORRICHTUNG ZUR VERDRAHTUNG EINES TECHNISCHEN SYSTEMS SOWIE TECHNISCHES SYSTEM**

(71) Anmelder: Siemens Aktiengesellschaft, 80333 München (DE)
(72) Erfinder: Jähnicke, Jens, 09112 Chemnitz (DE); Pöhler, Dirk, 08056 Zwickau (DE)

(57) **Zusammenfassung**

Die Erfindung betrifft ein Verfahren und eine Vorrichtung zur Bereitstellung elektrischer Verbindungen für ein technisches System. Durch die Erfindung besteht die Möglichkeit, ein technisches System, insbesondere einen Schaltschrank, der elektrische Komponenten (1, 2, 3) aufweist, mittels elektrischer Verbindungen (100) verknüpfen, wobei die elektrischen Verbindungen (100) mit einem Fused-Deposition-Modelling-Verfahren aufgetragen werden. Insbesondere zur Herstellung von Schaltschränken oder komplizierten Verteilereinheiten kann das erfindungsgemäße Verfahren dazu führen, dass umfangreich händisch auszuführende Arbeiten maschinell und automatisiert ablaufen. Durch den Einsatz der Erfindung ist weiter ein hohes Maß von Individualisierung in der Herstellung von technischen Systemen, insbesondere von Schaltschränken möglich.

## Beschreibung

Die Erfindung betrifft ein Verfahren und eine Vorrichtung zur Bereitstellung elektrischer Verbindungen für ein technisches System. Weiter betrifft die Erfindung ein technisches System, insbesondere ein Schaltschrank.

Elektromechanisches System weisen elektrische Verbindungen zwischen elektrischen Komponenten auf. Die elektrischen Verbindungen sind beispielsweise Kabel, elektrische Leitungen sowie Leiterbahnen auf einer Platine. Insbesondere in Schaltschränken werden diese elektrischen Verbindungen durch Kabel realisiert, die händisch nach einer Vorgabe verlegt werden. Unter elektrischen Komponenten sind Schalter, Anschlüsse, Verbraucher, Verteilereinrichtungen sowie elektrische oder elektronische Bauteile zu verstehen.

DE 296 05 846 U1 beschreibt ein elektrisches Verteilersystem mit programmierbaren Verteilereinrichtungen, wobei die Verteilereinrichtungen eine nach der Montage der Verteilereinrichtungen den Verlauf von elektrischen Leitungen nach Vorgaben entsprechend ändern können.

DE 199 11 196 A1 beschreibt eine Schaltschrank-Elektrifiziereinrichtung mit einem Stromeingang und Stromabzweigvorrichtungen, an die elektrische Schaltschrankeinbauten anschließbar sind. Hierdurch entsteht eine Art elektrisches Bus-System.

Mit beiden technischen Lösungen lässt sich der Aufwand der Verdrahtung in einem elektrischen oder elektromechanischen System vereinfachen. Dennoch ist gemäß dem derzeitig bekannten Stand der Technik weiter eine hohe Anzahl von Arbeitsschritten notwendig, um ein elektrisches System gemäß Vorgaben mit elektrischen Leitungen auszustatten.

Daher ist es Aufgabe der Erfindung, auf eine einfache Art und Weise elektrische Verbindungen in einem technischen System bereitzustellen.

Die Aufgabe wird mit einem Verfahren gemäß Anspruch 1 gelöst.

Die Aufgabe wird weiter mit einer Vorrichtung zur Bereitstellung elektrischer Verbindungen gemäß Anspruch 8 gelöst.

Die Aufgabe wird weiter durch ein technisches System gelöst, dessen elektrische Verbindungen mit einem solchen Verfahren und/oder mit Hilfe einer solchen Vorrichtung erstellt worden sind.

Weitere vorteilhafte Ausgestaltungen der Vorrichtung und des Verfahrens sind in den abhängigen Ansprüchen beschrieben.

Das Verfahren zur Bereitstellung elektrischer Verbindung für ein technisches System erfolgt dergestalt, dass Anschlusselemente von elektrischen Komponenten mit elektrischen Verbindungen verknüpft werden. Die elektrischen Verbindungen weisen einen elektrisch leitenden Werkstoff auf. Im Unterschied zum bisherigen Stand der Technik erfolgt die Bereitstellung der elektrischen Verbindung mit einem 3D-Druck-Verfahren. Das Fused-Deposition-Modelling-Verfahren (im Folgenden als FDM-Verfahren bezeichnet) erzeugt elektrische Verbindungen aus einem elektrisch leitfähigen Material, regelmäßig einem Metall, zwischen Anschlusselementen der elektrischen Komponenten.

Die Vorrichtung zur Bereitstellung elektrischer Verbindungen für ein technisches System weist zumindest einen Extruder für einen elektrisch leitenden Werkstoff auf sowie eine Positioniereinrichtung und eine Steuereinrichtung, wobei die Steuereinrichtung mit Hilfe der Positioniereinrichtung den Extruder positioniert, wobei der Extruder zumindest zur Bereitstellung der elektrischen Verbindung anhand eines Schaltplans vorgesehen ist. Unter einer elektrischen Komponente wird ein Schalter, eine Platine, ein Verbraucher oder eine Steckleiste verstanden, wobei die elektrische Komponente Anschlusselemente aufweist. Die Anschlusselemente dienen zur Bestromung und/oder zur Übertragung von elektrischen Signalen von einer Komponente zu einer anderen elektrischen Komponente. Unter einer elektrischen Verbindung wurden bis jetzt regelmäßig Stromkabel verstanden, welches zwischen zwei Anschlusselementen von elektrischen Komponenten verläuft und die elektrische Verbindung zur Überführung von elektrischer Energie und/oder Informationen vorgesehen ist.

Die elektrischen Verbindungen bestehen aus einem elektrisch leitenden Werkstoff, wobei als elektrisch leitender Werkstoff insbesondere ein Metall mit einem geringen Schmelzpunkt, wie Zink, Blei, Kupfer, Zinn oder Legierung derselben, geeignet sind

Bei einer vorteilhaften Ausgestaltung des Verfahrens ist das 3D-Druck-Verfahren ein Fused-Deposition-Modeling-Verfahren.

Bei dem Fused-Deposition-Modelling-Verfahren (FDM-Verfahren) handelt es sich um das Schmelzen des elektrisch leitfähigen Werkstoffes, welches nachfolgend mit einem Extruder dergestalt auf einem Untergrund positioniert wird, dass eine geschlossene Verbindung zwischen einem Anschlusselement einer ersten elektrischen Komponente und dem Anschlusselement einer zweiten elektrischen Komponente bereit gestellt wird.

Das Fused-Deposition-Modelling-Verfahren wird insbesondere mit Kunststoffen im 3D-Druck-Bereich angewandt. Bei der hier beschriebenen Verbindung dient das Fused-Deposition-Modelling-Verfahren zu einem dreidimensionalen Druck von einem metallischen Werkstoff. Besonders vorteilhaft an dem Verfahren zur Bereitstellung einer elektrischen Verbindung für ein technisches System ist die direkte Umsetzung einer Vorgabe zur Verbindung elektrischer Komponenten mit Hilfe einer Vorrichtung zur Bereitstellung elektrischer Verbindungen. Mit Hilfe des FDM-Verfahrens ist ein besonders schnelles Erstellen von elektrischen Verbindungen möglich.

Anwendungsgebiete der Erfindung sind die Verdrahtung von Schaltschränken, die individuelle Bestückung und Verdrahtung von elektrischen und elektronischen Komponenten auf Leiterplatten oder Platinen, sowie die Beaufschlagung einer bereits vorhandenen Leiterplatte mit einem zusätzlichen elektrisch leitenden Werkstoff, z.B. zur Verringerung des Widerstandes einzelner elektrischer Verbindungen.

Die Vorrichtung zur Bereitstellung elektrischer Verbindungen für ein technisches System kann analog einem handelsüblichen 3D-Drucker aufgebaut sein. Anstelle des, gewöhnlich verwendeten, Kunststoffes dient der Extruder bei der Erfindung zur Auftragung eines elektrisch leitfähigen Werkstoffes, insbesondere ein Metall mit einem geringen Schmelzpunkt oder einer metallischen Legierung.

Die Steuereinrichtung in der Vorrichtung zur Bereitstellung elektrischer Verbindungen dient zur Umwandlung eines Schaltplans in ein Antriebssignal für die Positioniereinrichtung, so dass anhand des Schaltplans die Positioniereinrichtung die elektrischen Verbindungen auf den Untergrund zwischen den Anschlusselementen der elektrischen Komponenten aufbringt. Die Positioniereinrichtung weist vorteilhaft mehrere Motoren auf, wobei die Motoren zur Positionierung des Extruders oberhalb des Untergrunds vorgesehen sind. Als Extruder eignet sich ein 3D-Druckkopf gemäß dem Stand der Technik.

Bei einer vorteilhaften Ausgestaltung des Verfahrens wird der elektrisch leitende Werkstoff auf einen elektrischen Isolator aufgebracht. Als elektrischer Isolator eignet sich ein hoch schmelzender Kunststoff sowie ein Epoxidharz oder ein Keramikwerkstoff.

Diese Ausgestaltung kann auch dergestalt erfolgen, dass, insbesondere mit Hilfe eines Extruders, auf eine elektrische Verbindung bereichsweise ein Isolator aufgebracht wird und auf diesen Isolator eine zweite elektrische Verbindung aufgebracht wird. Hierdurch lassen sich elektrische Verbindungen über-Kreuz verlegen, ohne dass händisch eingegriffen werden muss.

Vorteilhaft kann auch der elektrische Isolator in seinem Innenraum einen metallischen Werkstoff aufweisen, wobei der metallische Werkstoff zum Transport von Wärme dient, so dass der aufgetragene elektrisch leitende Werkstoff schneller erstarrt.

Mittels des hier beschriebenen Verfahrens lässt sich auch der elektrische Isolator mit Hilfe des Fused-Deposition-Modelling-Verfahrens auf einen elektrisch leitenden Werkstoff auftragen. Durch dieses mehrstufige Auftragen des elektrisch leitenden Werkstoffes lassen sich Kreuzungen von elektrischen Verbindungen einfach realisieren.

Vorteilhaft wird der elektrische Isolator entweder durch einen weiteren Extruder mit Hilfe des 3D-Drucks (Fused-Deposition-Modelling-Verfahren) oder mit einer Handhabungsvorrichtung zur Positionierung vorgefertigter Brückenelemente aufgebracht.

In einer weiteren vorteilhaften Ausgestaltung des Verfahrens ist der elektrische Isolator zumindest bereichsweise eine Platine.

Das Verfahren lässt sich besonders vorteilhaft zur Bestückung von Platinen in Verbindung mit einer gleichzeitigen Bereitstellung der elektrischen Verbindung der bestückten elektrischen Komponente auf einer Platine anwenden. Durch diese Anwendung der Erfindung ist eine Bestückung einer Platine mit Leiterbrücken gemäß einem individuellen Schaltplans möglich, ohne dass aufwändige Handhabungsaufgaben auftreten. Durch diese Ausführung können zum einen elektrische Leiterplatten einfach und kostengünstig in kleiner Stückzahl hergestellt werden. Weiter kann insbesondere beim Einsatz in einem Schaltschrank besonders einfach elektrische Verbindungen an schwer zugänglichen Stellen erstellt werden, insofern die Platinen in einem weiteren Arbeitsschritt an die entsprechende Stelle des Schaltschranks befestigt werden.

Bei einer weiteren vorteilhaften Ausgestaltung des Verfahrens werden die elektrischen Verbindungen mit einem 3D-Drucker gemäß einem Schaltplan erstellt.

Mit Hilfe eines handelsüblichen 3D-Druckers lassen sich elektrische Komponenten einfach verknüpfen, wobei der 3D-Drucker lediglich mit einem Extruder ausgestattet werden muss, der sich für ein Fused-Deposition-Modelling-Verfahren mit einem elektrisch leitenden Werkstoff eignet. Besonders vorteilhaft an dieser Ausgestaltung ist die breite Verwendungsmöglichkeit der Erfindung, da 3D-Drucker mittlerweile in vielen Fertigungsbetrieben angewandt werden und somit keine aufwändigen Neuinstallationen bei der Herstellung von elektrischen Verbindungen in einem technischen System notwendig sind. Zudem sind viele 3D-Drucker bereits einfach zur Erstellung von elektrisch leitfähigen Werkstoffen geeignet oder einfach umzurüsten. Der Schaltplan kann dabei individuell erstellt werden. Insbesondere kann noch kurz vor der eigentlichen Fertigung des individuell herzustellenden technischen Systems dieses noch verändert werden.

Bei einer weiteren vorteilhaften Ausgestaltung des Verfahrens werden die elektrischen Verbindungen und die elektrischen Komponenten des technischen Systems anhand von einem Schaltplan positioniert. Eine Positionierung der elektrischen Komponenten und der elektrischen Verbindungen in einem Arbeits- oder Planungsschritt birgt den Vorteil, dass Überkreuzungen von elektrischen Leitungen vermieden werden können.

Kreuzungen elektrischer Verbindungen können durch Brückenelemente realisiert sein, wobei die Brückenelemente zwei elektrische Kontakte aufweisen, so dass die Brückenelemente nach einer Bereitstellung einer elektrischen Verbindung über die bestehende elektrische Verbindung angeordnet werden. Zudem kann das Brückenelement selbst mit Hilfe des Fused-Deposition-Modelling-Verfahrens (aus einem elektrischen Isolator) erzeugt werden. Hierzu kann ein weiterer Extruder den Isolator bereichsweise über den aufgetragenen elektrisch leitenden Werkstoff aufbringen, wobei nach Härtung des elektrischen Isolators wiederum ein elektrisch leitender Werkstoff auf dem ausgehärteten elektrischen Isolator aufgebracht werden kann.

So entsteht ein Mehrschichtsystem, welches sich bereichsweise von dem Untergrund abhebt. Mittels eines Computerprogrammproduktes kann die Position der elektrischen Komponenten daher so gewählt sein, dass möglichst wenige Kreuzungen von elektrischen Verbindungen im technischen System auftreten.

Das Computerprogrammprodukt dient nach der Installation auf einem Computer zur Steuerung des 3D-Druckers sowie zur Berechnung der Position der elektrischen Verbindung.

Bei einer weiteren vorteilhaften Ausgestaltung des Verfahrens werden neben den elektrischen Verbindungen auch weitere Teile des technischen Systems, insbesondere der elektrischen Komponenten, mit dem 3D-Druck-Verfahren erstellt.

Auch in dieser Ausgestaltung des Verfahrens ist eine besonders schnelle Herstellung des technischen Systems mit Hilfe des FDM-Verfahrens möglich.

Hierzu ist eine erweiterte Vorrichtung zur Bereitstellung elektrischer Verbindungen vorteilhaft, wobei die Vorrichtung zur Bereitstellung elektrischer Verbindungen einen weiteren Extruder aufweist, der für einen nicht elektrisch leitenden Werkstoff, also einen elektrischen Isolator, geeignet ist. Regelmäßig besteht ein technisches System sowohl aus elektrischen Leitern, die aus einem elektrisch leitenden Werkstoff gefertigt sind, und einem elektrischen Isolator, in der Regel Kunststoff. Mit gängigen Vorrichtungen zur Bereitstellung von dreidimensionalen Strukturen (handelsübliche 3D-Drucker) lassen sich Teile von elektrischen Komponenten anhand von Vorgaben drucken. Mit dem hier beschriebenen Verfahren würde sich vorteilhaft ein gesamter Schaltschrank oder ein weiteres technisches System anhand von Vorgaben erstellen lassen, ohne dass weitere händisch auszuführende Arbeitsschritte erforderlich sind.

Durch ein solches Verfahren wären praktisch jegliche technische Systeme anhand von Schaltplänen und/oder Konstruktionszeichnungen sowie weiteren Vorgaben herzustellen. Somit könnte eine vollständig individualisierte Fertigung technischer Systeme erfolgen, die speziell nach Kundenwünschen geändert, angepasst oder erstellt werden und die zu einem günstigen Herstellungspreis bereitzustellen sind. Hierzu bedarf es vorteilhaft einer Vorrichtung zur Bereitstellung elektrischer Verbindungen, die weitere Extruder für andere Werkstoffe, wie beispielsweise Keramikwerkstoffe, Kunststoffe oder faserdurchwobene Werkstücke, mittels eines geeigneten FDM-Verfahrens zu erstellen sind.

Bei der zuletzt genannten Ausgestaltung des Verfahrens ist das bevorzugte 3D-Druck-Verfahren ein Fused-Deposition-Modelling-Verfahren. Besonders Vorteilhaft an dem FDM-Verfahren ist das breite Spektrum von Materialien, die für das FDM-Verfahren geeignet sind.

Bei einer vorteilhaften Ausgestaltung der Vorrichtung weist die Vorrichtung einen Extruder für einen elektrisch leitenden Werkstoff und einen weiteren Extruder für einen elektrischen Isolator auf. Durch das Zusammenspiel des Extruders und des weiteren Extruders können elektrische Verbindungen übereinander und zur Verknüpfung elektrischer Komponenten dergestalt erzeugt werden, dass ein gesamter Schaltschrank oder ein gesamter Verteilerkasten individuell bereitgestellt werden kann.

Bei einer weiteren vorteilhaften Ausgestaltung der Vorrichtung weist die Vorrichtung weiter eine Isolationseinheit auf, die zur Isolation von elektrischen Verbindungen mit einem elektrischen Isolator vorgesehen ist. Eine Isolationseinheit dient vorteilhaft zur Isolation von elektrischen Verbindungen, die mit einem erfindungsgemäßen Verfahren erzeugt worden sind. Eine Isolationseinheit kann sowohl als 3D-Drucker realisiert sein, wobei mit Hilfe des Fused-Deposition-Modelling-Verfahrens ein Kunststoff auf eine elektrische Verbindung aufgebracht wird. Bei einer Isolationseinheit kann es sich aber auch um eine Vorrichtung zur Beaufschlagung eines Untergrunds, wie beispielsweise eine Lackiervorrichtung handeln, wobei der Isolator großflächig auf einen Untergrund und/oder auf eine elektrisch leitende Verbindung aufgebracht wird.

Eine solche Isolationseinheit kann die Bereitstellung des technischen Systems anhand eines Verfahrens zur Bereitstellung elektrischer Verbindungen erheblich beschleunigen.

In einer weiteren vorteilhaften Ausgestaltung der Vorrichtung dient zur Bereitstellung des elektrischen Isolators ein weiterer Extruder. Der weitere Extruder kann beispielsweise mit einem isolierenden Kunststoff oder einem Keramikwerkstoff zur Auftragung des Isolators auf einen Untergrund und/oder auf einen elektrisch leitfähigen Werkstoff dienen.

Die Erfindung kann insbesondere zur Bereitstellung elektrischer Verbindungen und/oder zum Anschluss von elektrischen Komponenten in einem Schaltschrank dienen. Weitere Anwendungsgebiete sind individuell gestaltete Kontaktelemente bzw. die Bereitstellung von solchen oder die Bereitstellung von Verteilereinheiten, insbesondere zur Verteilung von elektrischer Energie und/oder Informationen, die durch elektrische Signale von einer ersten in eine zweite Komponente überführt werden.

Im Folgenden wird die Erfindung anhand von Figuren näher erläutert und beschrieben. Einzelne Merkmale, die in den Figuren gezeigt werden, können durch den Fachmann durch Kombination oder einzelnes Herausgreifen zu neuen Ausführungsbeispielen führen, ohne dass der Fachmann das Wesen der Erfindung überschreitet. Es zeigen
- FIG 1: eine Verknüpfung von zwei Komponenten,
- FIG 2: eine Vorrichtung zur Bereitstellung einer elektrischen Verbindung sowie
- FIG 3: eine Kreuzung isolierter elektrischer Verbindungen.

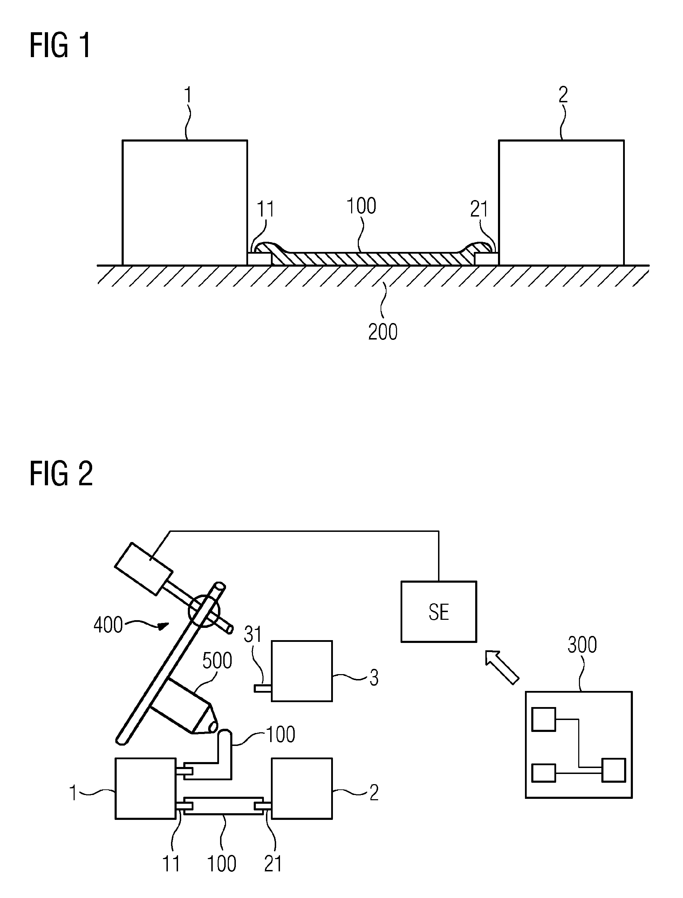

FIG 1 zeigt eine Verknüpfung von zwei Komponenten 1, 2. Hierbei ist die erste elektrische Komponente 1 mit einem elektrisch leitfähigen Werkstoff 100 mit einer zweiten elektrischen Komponente 2 verknüpft. Die elektrische Komponenten 1, 2 sind auf einem Untergrund 200 lokalisiert. Sowohl die erste elektrische Komponente 1 als auch die zweite elektrische Komponente 2 weisen Anschlusselemente 11, 21 auf. Die Anschlusselemente 21, 11 sind mit einer elektrisch leitfähigen Verbindung 100, die aus einem elektrisch leitfähigen Werkstoff, vorzugsweise einem Metall, besteht, durch eine elektrische Wirkverbindung verknüpft.

FIG 2 zeigt eine Vorrichtung zur Bereitstellung einer elektrischen Verbindung. Gezeigt sind drei elektrische Komponenten 1, 2, 3, wobei die erste elektrische Komponente 1 zwei Anschlusselemente 11 aufweisen. Die zweite Komponente 2 weist ebenfalls ein Anschlusselement 21 auf. Die dritte Komponente 3 weist ebenfalls ein Anschlusselement 31 auf. Die erste und die zweite elektrische Komponente 1, 2 sind mit einer elektrisch leitenden Verbindung 100 miteinander verknüpft. Zur Verknüpfung der ersten Komponente 1 und der dritten Komponente 3 dient ein Extruder 500, wobei der Extruder 500 zum Auftragen des elektrisch leitfähigen Werkstoffes, insbesondere einem Metall, im Bereich der Verbindungslinie der Anschlusselemente 11 der ersten Komponente 1 und des Anschlusselements 31 der dritten Komponente 3 vorliegt. Dargestellt ist hierbei lediglich eine unvollständig vorliegende Verknüpfung zwischen dem Anschlusselement 11 der ersten Komponente 1 und dem Anschlusselement 31 der drittenelektrischen Komponente 3 gezeigt.

Mit Hilfe des Extruders wird der elektrisch leitfähige Werkstoff zu einer elektrisch leitfähigen Verbindung 100 zwischen den Anschlusselementen 11, 21, 31 der elektrischen Komponenten 1, 2, 3 auf einen Untergrund aufgetragen. Der Extruder wird durch eine Positioniereinrichtung 400 in die jeweilige Position überführt, wobei entlang der vorgesehenen Verlaufsstrecke des Extruders der Extruder 500 fortwährend ein elektrisch leitfähiges Material ausgibt, das zur Verbindung der ersten elektrischen Komponente 1 und der dritten elektrischen Komponente 3 vorgesehen ist. Die Positioniereinheit 400 wird über die Steuereinrichtung SE dergestalt gesteuert, dass die Position sowie die Menge des ausgegebenen Materials aus dem Extruder mit Hilfe der Positioniereinrichtung 400 und des Extruders 500 gesteuert und/oder geregelt werden.

Ein Schaltplan 300 wird dabei der Steuereinrichtung SE zur Verfügung gestellt, wobei der Schaltplan 300 über die vorgesehene Verbindung der einzelnen elektrischen Komponenten 1, 2, 3 die Steuereinrichtung SE informiert, so dass die Steuereinrichtung SE mit Hilfe der Positioniereinrichtung 400 die Bewegung des Extruders 500 steuert und/oder regelt. Vereinfacht kann eine solche Vorrichtung zur Bereitstellung einer elektrischen Verbindung 100 durch einen bekannten 3D-Drucker realisiert sein, wobei lediglich der 3D-Druckkopf, insbesondere der Extruder 500, zur Ausgabe eines elektrisch leitfähigen Werkstoffes geeignet ist. Mit Hilfe eines weiteren Extruders 500 (hier nicht gezeigt) können auch weitere Werkstoffe zur Verknüpfung der einzelnen Komponenten 1, 2, 3 vorgesehen sein.

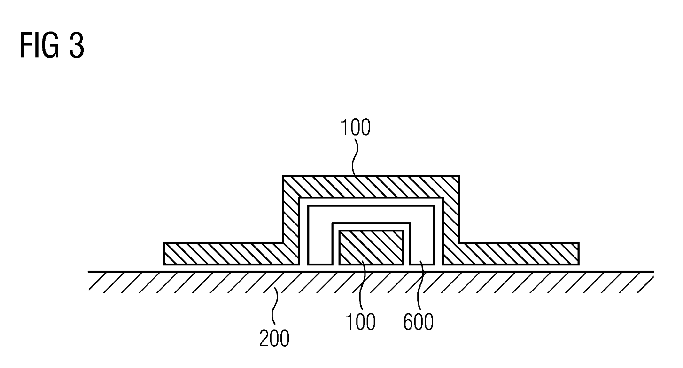

FIG 3 zeigt eine Kreuzung isolierter elektrischer Verbindungen 100. Hierbei ist eine elektrisch leitfähige Verbindung auf einem Untergrund 200 positioniert, wobei auf den Seiten, auf denen die elektrisch leitfähige Verbindung 100 nicht von dem Untergrund 200 abgedeckt wird, durch ein Brückenelement 600 verläuft eine weitere elektrisch leitende Verbindung 100. Durch eine bereichsweise Isolierung der elektrisch leitenden Verbindung 100 mit Hilfe des Brückenelements 600 lassen sich einfach und kostengünstig Kreuzungen elektrisch leitender Verbindungen 100 erstellen. Das Brückenelement 600 kann vorteilhaft mittels des Fused-Deposition-Modelling-Verfahrens auf den elektrischen Leiter 100 aufgebracht werden.

Zusammengefasst betrifft die Erfindung die Möglichkeit, ein technisches System, insbesondere einen Schaltschrank, der elektrische Komponenten 1, 2, 3 aufweist, mittels elektrischer Verbindungen 100 verknüpfen, wobei die elektrischen Verbindungen 100 mit einem Fused-Deposition-Modelling-Verfahren aufgetragen werden. Insbesondere zur Herstellung von Schaltschränken oder komplizierten Verteilereinheiten kann das erfindungsgemäße Verfahren dazu führen, dass umfangreich händisch auszuführende Arbeiten maschinell und automatisiert ablaufen. Durch den Einsatz der Erfindung ist weiter ein hohes Maß von Individualisierung in der Herstellung von technischen Systemen, insbesondere von Schaltschränken möglich.

## Patentansprüche

1. Verfahren zur Bereitstellung elektrischer Verbindungen (100) für ein technisches System, wobei Anschlusselemente (11, 21,31) von elektrischen Komponenten (1, 2, 3) mit elektrischen Verbindungen (100) verknüpft werden, wobei die elektrische Verbindungen (100) einen elektrisch leitenden Werkstoff aufweisen, wobei zumindest der elektrisch leitende Werkstoff mit einem 3D-Druck-Verfahren erstellt wird.

2. Verfahren nach Anspruch 1, wobei das 3D-Druck-Verfahren ein Fused-Deposition-Modelling-Verfahren ist.

3. Verfahren nach Anspruch 1, wobei der Werkstoff auf einem elektrischen Isolator (600) aufgebracht wird.

4. Verfahren nach einem der Ansprüche 1 oder 2, wobei der elektrische Isolator (600) zumindest Bereichsweis eine Platine ist.

5. Verfahren nach einem der vorangehenden Ansprüche, wobei die elektrischen Verbindungen (100) mit einem 3D-Drucker gemäß einem Schaltplan (300) erstellt werden.

6. Verfahren nach einem der vorangehenden Ansprüche, wobei die elektrischen Verbindungen (100) und die elektrischen Komponenten (1, 2, 3) des technischen Systems anhand von einem Schaltplan (300) positioniert werden.

7. Verfahren nach einem der vorangehenden Ansprüche, wobei neben den elektrischen Verbindungen (100) auch weitere Teile des technischen Systems mit dem 3D-Druck-Verfahren erstellt werden.

8. Verfahren nach Anspruch 7, wobei das 3D-Druck-Verfahren ein Fused-Deposition-Modeling-Verfahren ist.

9. Vorrichtung zur Bereitstellung elektrischer Verbindungen (100) für ein technisches System, aufweisend zumindest einen Extruder (500) für einen elektrisch leitenden Werkstoff, und eine Positioniereinrichtung (400) und eine Steuereinrichtung (SE), wobei die Steuereinrichtung (SE) mit Hilfe der Positioniereinrichtung (400) den Extruder (500) positioniert, wobei der Extruder (500) zumindest zur Bereitstellung der elektrischen Verbindungen (100) anhand eines Schaltplans (300) vorgesehen ist.

10. Vorrichtung nach Anspruch 9, aufweisend den Extruder (500) für den elektrisch leitenden Werkstoff und einen weiteren Extruder (500) für einen elektrischen Isolator (600).

11. Vorrichtung nach einem der Ansprüche 9 oder 10, weiter aufweisend eine Isolationseinheit (700), die zur Isolation von elektrischen Verbindungen mit einem elektrischen Isolator (600) vorgesehen ist.

12. Vorrichtung nach Anspruch 11, wobei zur Bereitstellung eines elektrischen Isolators (600) ein weiterer Extruder (500) vorgesehen ist.

13. Technisches System, insbesondere einen Schaltschrank, aufweisend zumindest eine elektrische Verbindung (100), die mit einem Verfahren gemäß einem der Ansprüche 1 bis 6 bereitgestellt worden ist.
